Europäisches Patentamt

European Patent Office

Office européen des brevets

(11) Publication number: **0 100 199**
**B1**

(12) ## EUROPEAN PATENT SPECIFICATION

(45) Date of publication of patent specification: **20.09.89**

(51) Int. Cl.⁴: **H 01 L 27/14**

(21) Application number: **83304183.3**

(22) Date of filing: **19.07.83**

(54) **An interline transfer CCD image sensor and a drive circuit therefor.**

(30) Priority: **19.07.82 JP 126552/82**

(43) Date of publication of application:
**08.02.84 Bulletin 84/06**

(45) Publication of the grant of the patent:
**20.09.89 Bulletin 89/38**

(84) Designated Contracting States:
**DE FR GB**

(56) References cited:
**GB-A-2 065 974**
**US-A-4 141 024**
**US-A-4 194 213**

(73) Proprietor: **SHARP KABUSHIKI KAISHA**
**22-22 Nagaike-cho Abeno-ku**
**Osaka 545 (JP)**

(72) Inventor: **Miyatake, Shigehiro**
**12-1-606 Dogashita-2-chome**
**Tennoji-ku Osaka-shi (JP)**

(74) Representative: **Wright, Peter David John et al**
**R.G.C. Jenkins & Co. 26 Caxton Street**
**London SW1H 0RJ (GB)**

Courier Press, Leamington Spa, England.

## Description

The present invention relates to a CCD (Charge Coupled Device) image sensor including PN junction photosensor elements, and is more particularly concerned with the problem of isolation between the individual photosensor elements of such a CCD image sensor.

There has recently been developed, a solid state image sensor for use in a color video camera as disclosed in published UK Patent Application GB 2,065,974A, the disclosure of which corresponds to the precharacterising parts of claims 1 and 6, respectively, and is to be deemed as incorporated herein by reference.

Solid state image sensors can generally be classified as being of either the XY address image sensor type or the CCD image sensor type. In particular, CCD image sensors have been developed because of their advantageous S/N ratio (Signal to Noise ratio), this being due to their small output capacity. An interline transfer CCD image sensor including PN junction photodiodes shows a high sensitivity to blue light, and shows a high resolution enabling it to be used with a mosaic color filter. However, conventional CCD image sensors have required a complicated structure to improve their characteristics, so that the number of required masks during manufacture is great and the risk of mask slip and the resulting inaccuracy in structure is high.

## Summary of the invention

US Specification No. 4,194,213 describes an interline transfer CCD image sensor which includes a matrix of charge-coupled photosensor elements and a plurality of vertical CCD shift registers, with transfer portions located between each of the elements and the associated shift register. A horizontal CCD shift register is provided at the corresponding ends of the vertical shift registers. The device includes a semiconductor substrate with an insulating layer thereon, and a transparent electrode on the insulating layer. The vertical shift registers include two sets of shifting electrodes beneath the transparent electrode and spaced from the surface of the substrate by different thickness of the insulating layer. Clock signals applied to the shifting electrodes effect charge movement along the vertical shift registers, and clock pulses applied periodically to the transparent electrode effect transfer of charges from the sensor elements to the vertical shift registers.

The present invention aims to provide a simple structure for a CCD image sensor, in which the need for channel stoppers for isolating photodiodes can be eliminated.

According to the present invention there is provided a CCD image sensor of the interline transfer type comprising a plurality of PN junction photodiodes formed in a substrate and aligned in a matrix fashion and a plurality of CCD shift registers having CCD channels formed in said substrate, the photodiodes in each line of the matrix being coupled to respective stages of an associated CCD shift register by respective transfer gate regions, the said CCD shift registers having register electrode means which extend over said CCD channels of the shift registers and which include portions extending over regions between adjacent photodiodes of the same line, said register electrode means also extending over said transfer gate regions to the edges of the photodiodes, and drive circuit means operable to apply the clock signals to said register electrode means so as to cause accumulated charges to transfer through said transfer gate regions to the register stages and to cause those charges to shift along the registers, characterised by the absence in said substrate of any channel stoppers between the adjacent photodiodes in the same line, and in that said drive circuit means is so arranged that when a transfer signal level is applied to the register electrode means to effect said charge transfer, the signal level applied to said portions of said electrode means between adjacent photodiodes is lower than said transfer signal level thereby to maintain electrical isolation between said adjacent photodiodes of the same line despite said absence of channel stoppers.

According to the present invention there is also provided a drive circuit for a CCD image sensor of the interline transfer type comprising a plurality of PN junction photodiodes formed in a substrate and aligned in a matrix fashion and a plurality of CCD shift registers having CCD channels formed in said substrate, the photodiodes in each line of the matrix being coupled to respective stages of an associated CCD shift register by respective transfer gate regions, the said CCD shift registers having register electrode means which extend over said CCD channels of the shift registers and which include portions extending over regions between adjacent photodiodes of the same line, said register electrode means also extending over said transfer gate regions to the edges of the photodiodes, said drive circuit being operable to apply clock signals to said register electrode means so as to cause accumulated charges to transfer through said transfer gate regions to the register stages and to cause those charges to shift along the registers, characterised in that said drive circuit means is so arranged that when a transfer signal level is applied to the register electrode means to effect said charge transfer, the signal level applied to said portions of said electrode means between adjacent photodiodes is lower than said transfer signal level thereby to maintain electrical isolation between said adjacent photodiodes of the same line despite the absence in said substrate of any channel stoppers between the adjacent photodiodes in the same line.

The present invention will be better understood from the detailed description given hereinbelow and the accompanying drawings which are given by way of illustration only, and thus are not limitative of the present invention and wherein:

Fig. 1(a) is a plan view of an esssential part of a conventional interline transfer CCD image sensor;

Fig. 1(b) is a sectional view taken along line I—I' of Fig. 1(a);

Fig. 1(c) is a sectional view taken along line II—II' of Fig. 1(a);

Fig. 2 is a time chart showing drive signals applied to the conventional interline transfer CCD image sensor of Figs. 1(a)—1(c);

Fig. 3(a) is a plan view of an essential part of the interline transfer CCD image sensor of an embodiment of the present invention;

Fig. 3(b) is a sectional view taken along line III—III' of Fig. 3(a);

Fig. 3(c) is a sectional view taken along line IV—IV' of Fig. 3(a);

Figs. 4 and 5 are time charts showing drive signals applied to the interline transfer image sensors of Figs. 3(a)—3(c) and Figs. 7(a)—7(b);

Figs. 6(a) and 6(b) are schematic charts showing channel potentials under the electrodes 10, 7, 8 and 9 receiving the clock signals at $t=t_1$ as shown in Figs. 4 and 5, respectively;

Fig. 7(a) is a plan view of an essential part of the interline transfer CCD image sensor of another embodiment of the present invention;

Fig. 7(b) is a sectional view taken along line V—V' of Fig. 7(a); and

Fig. 7(c) is a sectional view taken along line VI—VI' of Fig. 7(a).

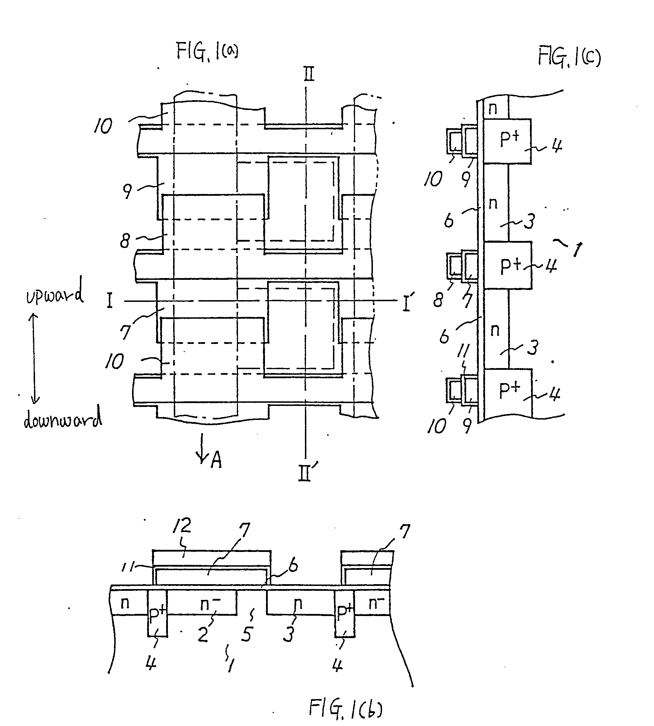

In order to facilitate a more complete understanding of the present invention, the conventional interline transfer CCD image sensor including PN junction photodiodes, will be first described with reference to Figs. 1(a)—1(c).

An $N^-$ diffusion layer 2 is formed on a P-type semiconductor substrate 1 to provide a buried channel for a CCD shift register. An N diffusion layer 3 is also formed on the P-type semiconductor substrate 1 to provide a PN junction photodiode. The $N^-$ diffusion layer 2 and the N diffusion layer 3 are formed with a predetermined distance therebetween. A plurality of CCD shift registers are formed as columns in the P-type semiconductor substrate 1. Each of CCD shift registers includes a plurality of CCD shift register elements. Each photodiode corresponds to a respective CCD shift register element. The $N^-$ diffusion layer 2 and the N diffusion layer 3 are connected via a P-type semiconductor transfer gate region 5. A highly doped P-type semiconductor channel stopper 4, which functions as a potential barrier, is formed in the part of the substrate not including the $N^-$ diffusion layer 2, the N diffusion layer 3, and the transfer gate 5.

On the other hand, an insulator 6 made of $SiO_2$ is formed on the semiconductor substrate 1 to cover the substrate surface. Polysilicon electrodes 7, 8, 9 and 10 for the shift register elements are formed on the insulator 6 of the P-type semiconductor substrate 1. The polysilicon electrodes 7 and 9 are formed as the first-stage or lower layer electrodes, and the polysilicon electrodes 8 and 10 are formed as the second-stage or upper layer electrodes. An insulator film 11 made of $SiO_2$ is interpositioned between the electrodes of different layers, to isolate the electrodes from each other. The polysilicon electrodes 7, 8, 9 and 10 are formed above the $N^-$ diffusion layer 2 and the transfer gate region 5 of the shift register. An aluminium light shield 12 is formed over the $N^-$ diffusion layer 2 of the shift register and the transfer gate region 5.

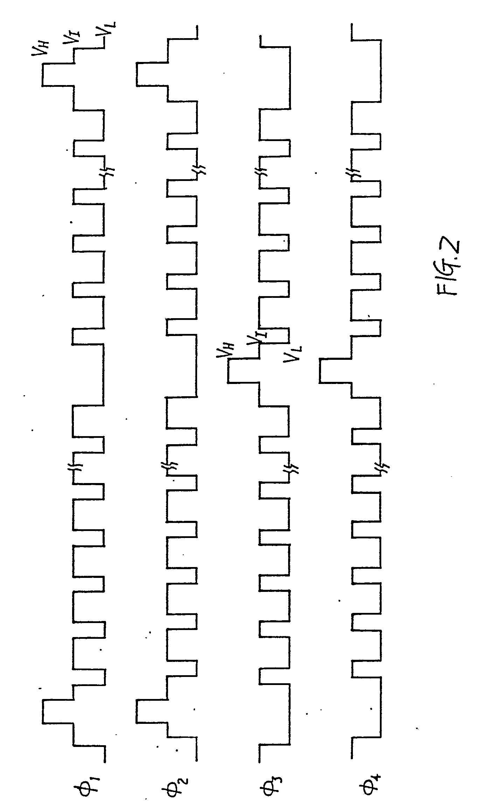

Clock signals $\phi_1$, $\phi_2$, $\phi_3$ and $\phi_4$ as shown in Fig. 2 and applied to the polysilicon electrodes 10, 7, 8 and 9, respectively. The clock signals $\phi_1$, $\phi_2$, $\phi_3$ and $\phi_4$ have three signals levels $V_L$, $V_I$ and $V_H$. When the clock signal shows the signal level $V_L$ or $V_I$, signal charges condensed in the shift register element are transferred in the direction A of Fig. 1(a) (downward). When the clock signal shows the signal level $V_H$, signal charge accumulated in the photodiodes 3 are transferred horizontally to the adjacent shift register element via the transfer gate region 5.

In the CCD image sensor having the above construction, the electrodes of the shift register elements are provided for wiring on the P-type semiconductor substrate between neighboring photodiodes. The channel stopper 4 has to be provided under the wiring to prevent a charge mixing or crosstalk between the neighboring photodiodes when the clock signals applied to the shift register elements show a high signal level. However, because the channel stoppers 4 are prepared by different steps, variations in their characteristics owing to masking slips are produced.

An embodiment of the present invention can avoid the above problems and will be described as follows:

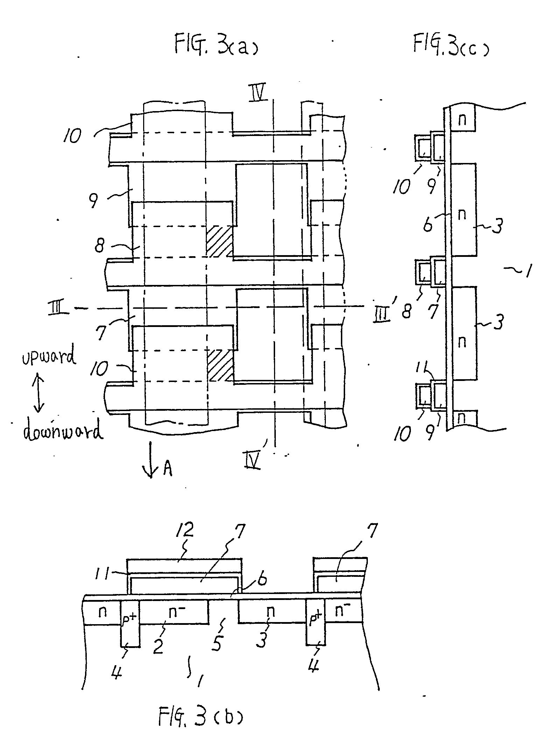

In Figs 3(a)—3(c) like elements corresponding to those of Figs. 1(a)—1(c) are indicated by like numerals. The difference between the CCD image sensors of Figs. 1(a)—1(c) and Figs. 3(a)—3(c) is described as follows.

As can be seen from Fig. 3(c), no channel stoppers are provided between adjacent N diffusion layers 3 forming the photodiodes. The channel stopper 4 is provided only between N diffusion layer 3 for the photodiode and the $N^-$ diffusion layer 2 for the shift register as shown in Fig. 3(b). In this construction, the variations in characteristics with masking slips or overlapping between the photodiodes and the channel stopper can be remarkably reduced. The N diffusion layer 3 for the photodiode may be formed by the self-alignment for the polysilicon electrodes 7, 8, 9 and 10.

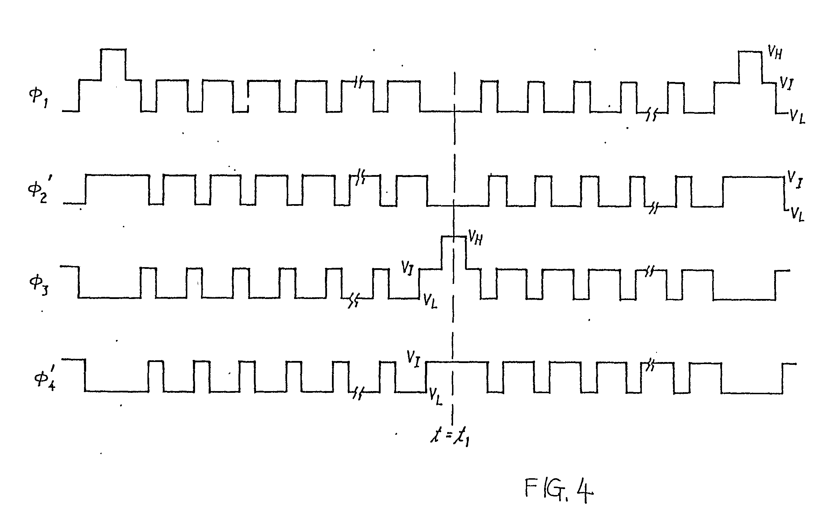

Electrodes 10, 7, 8 and 9 are formed on the silicon semiconductor substrate 1 as in the structure of Figs. 1(a)—1(c). Clock signals $\phi_1$, $\phi'_2$, $\phi_3$ and $\phi'_4$ as shown in Fig. 4 are applied to the electrodes 10, 7, 8 and 9 respectively. The clock signals $\phi'_2$ and $\phi'_4$ applied to the first-stage, or lower layer polysilicon electrodes 7 and 9 vary between signal levels $V_L$ and $V_I$. The clock signals $\phi_1$ and $\phi_3$ applied the second-stage, or upper layer polysilicon electrodes 10 and 8 vary among signal levels $V_L$, $V_I$, and $V_H$.

When the clock signals $\phi_1$ or $\phi_3$ show the signal level $V_H$, signal charges accumulated in a photodiode are transferred horizontally into the adjacent shift register element through the portion just under the electrode 10 or 8 as shown in the oblique line area in Fig. 3(a). Though the photodiodes are not isolated by channel stoppers, the clock signals applied to the electrodes 7 and 9 which are located between the photodiodes are in the signal level $V_L$ or $V_I$ in order to prevent signal charge mixing or cross talk.

When the clock signals $\phi_1$ or $\phi_3$ are varied between the signal levels $V_L$ and $V_I$, the signal charges in the shift register elements are transferred into the adjacent shift register elements in the dierction A as shown in Fig. 3(a) (downward). In the above construction, the channel stopper between the photodiodes is not necessary.

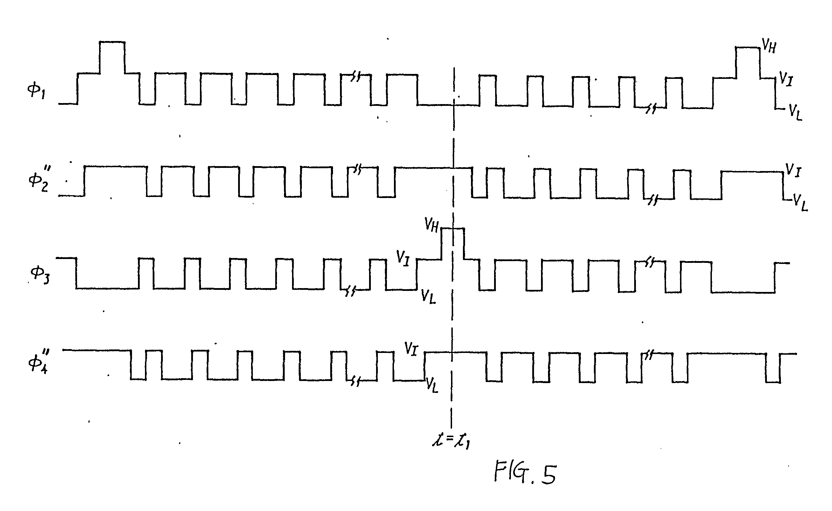

Fig. 5 is a time chart showing another set of drive signals which can be used in the described embodiment of the present invention. Clock signals $\phi_1$, $\phi''_2$, $\phi_3$ and $\phi''_4$ as shown in Fig. 5 are applied to the electrodes 10, 7, 8 and 9 respectively. To enhance transfer efficiency, at least two different clock signals should simultaneously take the signal level $V_I$ at a preselected time. For example, the clock signals $\phi_1$ and $\phi_3$ take the signal level $V_I$ about a few tens nsec at a preselected time. However, this signal overlap is neglected for the purpose of this description.

In Fig. 4, the clock signals $\phi_1$ and $\phi_3$ or $\phi'_2$ and $\phi'_4$ are inverted with respect to each other except when the clock signals are at the signal level $V_H$. In Fig. 5, on the contrary, when the clock signal $\phi_3$ is at the signal level $V_H$, the clock signal $\phi''_2$ is at the signal level $V_I$. When the clock signal $\phi_1$ is at the signal level $V_H$, the clock signal $\phi''_4$ is at the signal level $V_I$.

This difference is highly desirable for the interline transfer CCD image sensor of the present invention and will be described as follows.

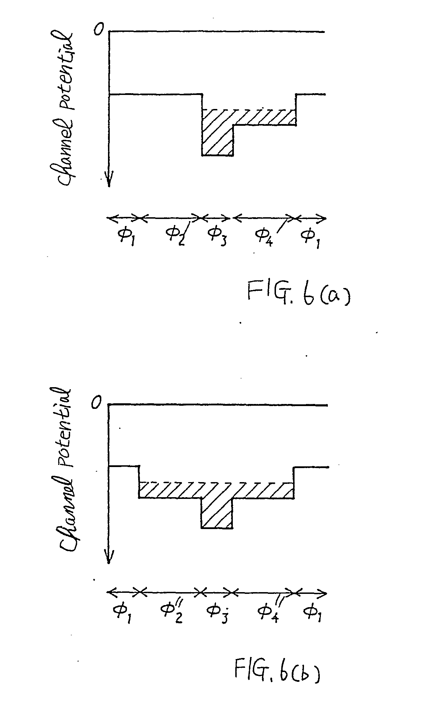

Figures 6(a) and 6(b) are schematic charts showing channel potentials under the electrodes 10, 7, 8 and 9 receiving the clock signals at $t=t_1$ as shown in Figs. 4 and 5 respectively.

In Figs. 6(a) and 6(b), each dotted line shows a channel potential of the photodiode, so that each area under each dotted line indicates a charge amount. The amount of the signal charges of Fig. 6(b) is significantly greater than that of the signal charges of Fig. 6(a) because the clock signal $\phi''_2$ shows the signal level $V_I$ at the beginning of the readout, $t=t_1$. If the clock signals of Fig. 5 are applied to the electrodes, the clock signals applied to the electrodes between the photodiodes again vary between the signal levels $V_L$ and $V_I$. Accordingly, signal charge mixing or cross talk between the photodiodes does not happen.

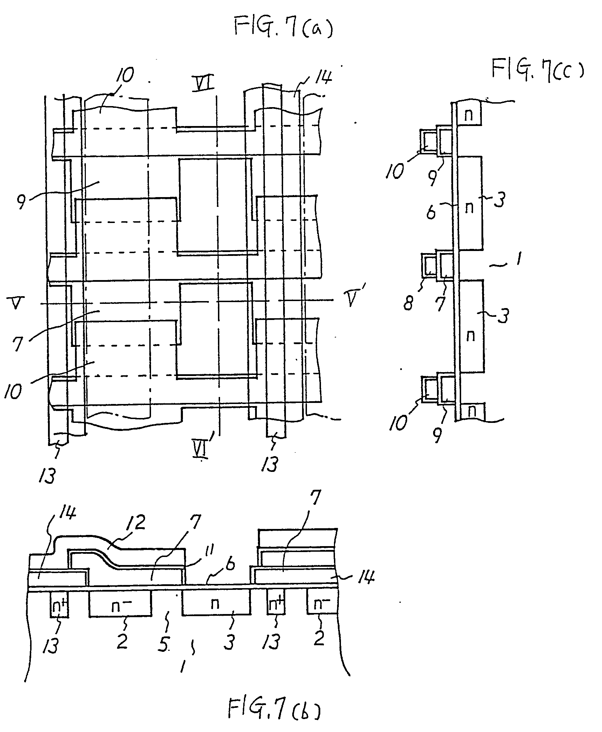

Fig. 7(a)—7(c) show a CCD image sensor according to another embodiment of the invention. An overflow control gate 14 and an overflow drain 13 are provided in order to prevent the so-called blooming suppression. Since the clock signals as shown in Figs. 4 and 5 are applied to the electrodes 10, 7, 8 and 9, the channel stopper between the photodiodes can be eliminated as in the embodiment of Fig. 3. Further, if the overflow control gate electrode 14 is formed with the first-stage layer polysilicon, the photodiode and the shift register are isolated by the electrode 14, and the channel stopper between the photodiodes and the shift register can be eliminated.

In a particular arrangement according to the present invention, the shift register includes 580 register elements, vertically. A horizontal shift register is connected to 475 such CCD vertical shift registers, whereby a 580×475 matrix image sensor is formed. A preferred frequency of the clock signals $\phi_1$, $\phi'_2$, $\phi''_2$, $\phi_3$, $\phi'_4$ and $\phi''_4$ is 15.625 KHz, and a preferred frequency of the horizontal shift register clock signals is 8.8125 MHz. Preferred voltage of the high ($V_H$), intermediate ($V_I$), low ($V_L$) signal levels are 4.5V, 0V, −4.5V, respectively.

## Claims

1. A CCD image sensor of the interline transfer type comprising a plurality of PN junction photodiodes (3) formed in a substrate (1) and aligned in a matrix fashion and a plurality of CCD shift registers having CCD channels (2) formed in said substrate, the photodiodes in each line of the matrix being coupled to respective stages of an associated CCD shift register by respective transfer gate regions (5), the said CCD shift registers having register electrode means (7, 8, 9, 10) which extend over said CCD channels (2) of the shift registers and which include portions extending over regions between adjacent photodiodes (3) of the same line, said register electrode means also extending over said transfer gate regions (5) to the edges of the photodiodes, and drive circuit means operable to apply the clock signals ($\phi_1$, $\phi_2'$, $\phi_3$, $\phi_4'$; $\phi_1$, $\phi_2''$, $\phi_3$, $\phi_4''$) to said register electrode means so as to cause accumulated charges to transfer through said transfer gate regions (5) to the register stages and to cause those charges to shift along the registers, characterised by the absence in said substrate of any channel stoppers between the adjacent photodiodes (3) in the same line, and in that said drive circuit means is so arranged that when a transfer signal level ($V_H$) is applied to the register electrode means (7, 8, 9, 10) to effect said charge transfer, the signal level ($V_1$ or $V_L$) applied to said portions of said electrode means between adjacent photodiodes is lower than said transfer signal level ($V_H$) thereby to maintain electrical isolation between said adjacent photodiodes (3) of the same line despite said absence of channel stoppers.

2. A CCD image sensor according to claim 1 characterised in that said register electrode means comprises lower electrode means (7, 9) extending over the CCD channels (2) of the shift registers and over said regions between adjacent photodiodes (3) and upper electrode means (8, 10) overlapping in part the lower electrode means (7, 9) and extending over the CCD channels (2) of the shift registers and over said regions between said adjacent photodiodes and in that the drive circuit means is operable to apply to the lower electrode means (7, 9) clock signals ($\phi_2'$, $\phi_4'$; $\phi_2''$, $\phi_4''$) having two signal levels ($V_I$, $V_L$) and to apply to the upper electrode means (8, 10) clock signals ($\phi_1$, $\phi_3$) having said two signal levels ($V_I$, $V_L$) during charge shifting along the shift register, and a third signal level ($V_H$) higher than both of said two signal levels to effect said charge transfer.

3. A CCD image sensor according to claim 2 characterised in that said upper electrode means comprises first (10) and second (8) sets of alternate upper electrodes and said lower electrode means comprises corresponding first (9) and second (7) sets of alternate lower electrodes, and in that at each time ($t_1$) of application of said third signal level ($V_H$) the clock signals ($\phi_2''$, $\phi_4''$) applied to both of said first and second sets of lower electrodes (7, 9) are at the higher of said two levels ($V_I$, $V_L$).

4. A CCD image sensor according to claim 3 characterised in that said drive circuit is arranged to apply said third signal level ($V_H$) alternately to said first (10) and second (8) sets of upper electrodes.

5. A CCD image sensor according to any preceding claim characterised in that the stages of each shift register are electrically isolated from an adjacent line of said photodiodes by a channel stopper (4) which does not extent between the adjacent photodiodes to which the register stages are coupled.

6. A drive circuit for a CCD image sensor of the interline transfer type comprising a plurality of PN junction photodiodes (3) formed in a substrate (1) and aligned in a matrix fashion and a plurality of CCD shift registers having CCD channels (2) formed in said substrate, the photodiodes in each line of the matrix being coupled to respective stages of an associated CCD shift register by respective transfer gate regions (5), the said CCD shift registers having register electrode means (7, 8, 9, 10) which extend over said CCD channels (2) of the shift registers and which include portions extending over regions between adjacent photodiodes (3) of the same line, said register electrode means also extending over said transfer gate regions (5) to the edges of the photodiodes, said drive circuit being operable to apply clock signals ($\phi_1$, $\phi_2'$, $\phi_3$, $\phi_4'$; $\phi_1$, $\phi_2''$, $\phi_3$, $\phi_4''$) to said register electrode means so as to cause accumulated charges to transfer through said transfer gate regions (5) to the register stages and to cause those charges to shift along the registers, characterised in that said drive circuit means is so arranged that when a transfer signal level ($V_H$) is applied to the register electrode means to effect said charge transfer, the signal level ($V_I$ or $V_L$) applied to said portions of said electrode means between adjacent photodiodes (3) is lower than said transfer signal level ($V_H$) thereby to maintain electrical isolation between said adjacent photodiodes (3) of the same line despite the absence in said substrate of any channel stoppers between the adjacent photodiodes in the same line.

**Patentansprüche**

1. CCD-Bildsensor mit Zwischenzeilen-Ladungsübergang und mehreren Photodioden (3) mit PN-Übergang, die in einem Substrat (1) in Matrixanordnung ausgebildet sind, mit mehreren im Substrat ausgebildeten und CCD-Kanäle (2) aufweisenden CCD-Schieberegistern, bei dem die Photodioden jeder Matrixzeile über entsprechende Übertragungs-Gatebereiche (5) mit jeweiligen Stufen eines zugeordneten CCD-Schieberegisters verbunden sind und die CCD-Schieberegister Speicherelektroden (7, 8, 9, 19) aufweisen, die sich über die CCD-Kanäle (2) erstrecken und Abschnitte enthalten, die sich über Bereiche zwischen einander benachbarten Photodioden (3) einer Zeile erstrecken, und bei dem die Speicherelektroden sich auch über die Übertragungs-Gatebereiche (5) bis zu den Kanten der Photodioden erstrecken sowie mit einer Treiberstufe zum Anlegen von Taktsignalen ($\phi_1$, $\phi_2'$, $\phi_3$, $\phi_4'$; $\phi_1$, $\phi_2''$, $\phi_3$, $\phi_4''$) an die Speicherstufen, um angesammelte Ladungen über die Übertragungsgitterbereiche (5) den Registerstufen zuzuführen und um die übertragenen Ladungen entlang den Registern zu verschieben daudrch gekennzeichnet, daß

zwischen einander benachbarten Photodioden (3) einer Zeile im Substrat keine Kanalsperren vorhanden sind, und daß

die Treiberstufe bei Anliegen eines Übertragungssignalpegels ($V_H$) an den Speicherelektroden (7, 8, 9, 10) zur Ladungsübertragung zwischen einander benachbarten Photodioden vorhandenen Bereichen einen Signalpegel ($V_I$ oder $V_L$) zuführt, der kleiner ist als der Übertragungssignalpegel ($V_H$), so daß trotz fehlender Kanalsperren zwischen den einander benachbarten Photodioden (3) einer Zeile eine Potentialsperre aufrechterhalten bleibt.

2. CCD-Bildsensor nach Anspruch 1, dadurch gekennzeichnet, daß die Speicherelektroden untere Elektroden (7, 9), die sich über die CCD-Kanäle (2) der Schieberegister und über den Bereich zwischen den einander benachbarten Photodioden (3) erstrecken, und obere Elektroden (8, 10) aufweisen, die teilweise die unteren Elektroden (7, 9) überlappen und sich über die CCD-Kanäle (2) der Schieberegister und über Bereiche zwischen den einander benachbarten Photodioden erstrecken, und daß die Treiberstufe den unteren Elektroden (7, 9) Taktsignale ($\phi_2'$, $\phi_4'$; $\phi_2''$, $\phi_4''$) mit zwei Signalpegel ($V_I$, $V_L$) zuführt, und so den oberen Elektroden (8, 10) Taktsignale ($\phi_1$, $\phi_3$) anlegt, die diese zwei Signalpegel ($V_I$, $V_L$) während der Ladungsverschiebung entlang den Schieberegistern aufweisen, und zur Auslösung der Ladungsübertragung einen dritten Signalpegel ($V_H$) liefert, der höher als die beiden Signalpegel ist.

3. CCD-Bildsensor nach Anspruch 2, dadurch gekennzeichnet, daß die oberen Elektroden einen ersten (10) und einen zweiten (8) Satz sichi einander abwechselnder Elektroden umfassen und die unteren Elektroden einen entsprechenden ersten (9) und zweiten (7) Satz einander abwechselnder Elektroden enthalten und daß zu jedem Eingabezeitpunkt ($t_1$) des dritten Signalpegels ($V_H$), die dem ersten und zweiten Satz der unteren Elektroden (7, 9) eingegebenen Taktsignale ($\phi_2''$, $\phi_4''$) den höheren der beiden Pegel ($V_I$, $V_L$) aufweisen.

4. CCD-Bildsensor nach Anspruch 3, dadurch gekennzeichnet, daß die Treiberstufe den dritten Signalpegel ($V_H$) abwechselnd um den ersten (10) und den zweiten (8) Satz der oberen Elektroden anlegt.

5. CCD-Bildsensor nach einem der vorstehenden Ansprüche 1 bis 4, dadurch gekennzeichnet, daß die Stufen eines jeden Schieberegisters von einer benachbarten Zeile der Photodioden durch eine Kanalsperre elektrisch isoliert sind, die sich nicht zwischen einander benachbarten Photodioden erstreckt, an denen die Speicherstufen angeschlossen sind.

6. Treiberstufe für einen CCD-Bildsensor mit Zwischenzeilen-Ladungsübergung und mehreren Photodioden (3) mit PN-Übergang, die in einem Substrat (1) in Matrixanordnung ausgebildet sind, mit mehreren im Substrat ausgebildeten und CCD-Kanäle (2) aufweisende CCD-Schieberegistern, bei denen die Photodioden jeder Matrixzeile über entsprechende Übertragungs-Gatebereiche (5) mit jeweiligen Stufen eines zugeordneten CCD-Schieberegisters verbunden sind und die CCD-Schieberegister Speicherelektroden (7, 8, 9, 10) aufweisen, die sich über die CCD-Kanäle (2) erstrecken und Abschnitte enthalten, die sich über Bereiche zwischen einander benachbarten Photodioden (3) einer Zeile erstrecken, und bei dem die Speicherelektroden sich auch über die Übertragungs-Gatebereiche (5) bis zu dem Kanten der Photodioden erstrecken, wobei die Treiberstufe Taktsignale ($\phi_1$, $\phi_2'$; $\phi_3$, $\phi_4'$; $\phi_1$, $\phi_2''$, $\phi_3$, $\phi_4''$) an die Registerelektroden anlegt, um angesammelte Ladungen über die Übertragung-Gatebereiche (5) den Speicherstufen zuzuführen und um die übertragenen Ladungen entlang den Registern zu verschieben, dadurch gekennzeichnet, daß die Treiberstufe bei Anliegen eines Übertraungssignalpegels ($V_H$) an den Speicherelektroden (7, 8, 9, 10) zur Ladungsübertragung zwischen einander benachbarten Photodioden vorhandenen Bereichen einen Signalpegel ($V_I$ oder $V_L$) zuführt, der kleiner ist als der Übertragungssignalpegel ($V_H$), so daß trotz fehlender Kanalsperren im Subtrat zwischen einander benachbarten Photodioden einer Zeile eine Potentialsperre zwischen den benachbarten Photodioden (3) einer Zeile aufrechterhalten bleibt.

**Revendications**

1. Capteur d'images CCD du type à transfert interligne comprenant une pluralité de photodiodes à jonction PN (3) formées dans un substrat (1) et alignées à la manière d'une matrice et une pluralité de registres à décalage CCD comportant des canaux CCD (2) formés dans ledit substrat, les photodiodes de chaque ligne de la matrice étant couplées à des étages respectifs d'un registre à décalage CCD associé par des régions de grille de transfert respectives (5), lesdits registres à décalage CCD comportant des moyens d'électrodes de registre (7, 8, 9, 10) qui s'étendant par dessus lesdits canaux CCD (2) des registres à décalage et qui comprennent des parties s'étendant sur des régions entre des photodiodes adjacentes (3) de la même ligne, lesdits moyens d'électrodes de registre s'étendant également par dessus lesdites régions de grille de transfert (5) jusqu'aux bords des photodiodes, et des moyens de circuit de commande fonctionnant de manière à appliquer les signaux d'horloge ($\phi_1$, $\phi_2'$, $\phi_3$, $\phi_4'$; $\phi_1$, $\phi_2''$, $\phi_3$, $\phi_4''$) auxdits moyens d'électrodes de registre de manière à entraîner le transfert de charges accumulées par l'intermédiaire desdites régions de grille de transfert (5) jusqu'aux étages de registre et à entraîner le déplacement de ces charges le long des registres, caractérisé par l'absence dans ledit substrat de barrages de canaux quelconques entre les photodiodes adjacentes (3) de la même ligne, et en ce que lesdits moyens de circuit de commande sont prévus de telle manière que lorsqu'un niveau de signal de transfert ($V_H$) est appliqué aux moyens d'électrodes de registre (7, 8, 9, 10) pour effectuer ledit transfert de charge, le niveau de signal ($V_I$ ou $V_L$) appliqué auxdites parties desdits moyens d'électrodes entre des photodiodes adjacentes est inférieur audit niveau de signal de transfert ($V_H$) de manière à maintenir l'isolement électrique entre lesdites photodiodes adjacentes (3) de la même ligne malgré l'absence de barrages de canaux.

2. Capteur d'images CCD selon la revendication 1, caractérisé en ce que lesdits moyens d'électrodes de registres comprennent des moyens d'électrodes inférieures (7, 9) s'étendant par dessus les canaux CCD (2) des registres à décalage et par dessus lesdites régions entre des photodiodes adjacentes (3) et des moyens d'électrodes supérieures (8, 10) recouvrant en partie les moyens d'électrodes inférieures (7, 9) et s'étendant par dessus les canaux CCD (2) des registres à décalage et pas dessus lesdites régions entre lesdites photodiodes adjacentes et en ce que les moyens de circuit de commande fonctionnent de manière à appliquer aus moyens d'électrodes inférieures (7, 9) des signaux d'horloge ($\phi_2'$, $\phi_4'$; $\phi_2''$, $\phi_4''$) ayant deux niveaux de signaux ($V_I$, $V_L$) et à appliquer aux moyens d'électrodes supérieures (8, 10) des signaux d'horloge ($\phi_1$, $\phi_3$) ayant lesdits deux niveaux de signaux ($V_I$, $V_L$) pendant le déplacement des charges le long du registre à décalage, et un troisième niveau de signal ($V_H$) supérieur aux deux dits niveaux de signaux pour effectuer ledit transfert de charge.

3. Capteur d'images CCD selon la revendication 2, caractérisé en ce que lesdits moyens d'électrodes supérieures comprennent des premier (10) et second (8) jeux d'électrodes supérieures alternées et lesdits moynes d'électrodes inférieures comprennent des premier (9) et second (7) jeux correspondants d'électrodes inférieures alternées, et en ce que à chaque instant ($t_1$) d'application dudit troisième niveau de signal ($V_H$), les signaux d'horloge ($\phi_2''$, $\phi_4''$) appliqués aux deux

dits premier et second jeux d'électrodes inférieures (7, 9) sont au plus élevé des deux dits niveaux ($V_I$, $V_L$).

4. Capteur d'images CCD selon la revendication 3, caractérisé en ce que ledit circuit de commande est prévu de manière à appliquer ledit troisième niveau de signal ($V_H$) alternativement auxdits premier (10) et second (8) jeux d'électrodes supérieures.

5. Capteur d'images CCD selon l'une quelconque des revendications précédentes, caractérisé en ce que les étages de chaque registre à décalage sont électriquement isolés d'une ligne adjacente desdites photodiodes par un barrage de canal (4) qui ne s'étend pas entre les photodiodes adjacentes auxquelles les étages de registre sont couplés.

6. Circuit de commande pour un capteur d'images CCD du type à transfert interligne comprenant une pluralité de photodiodes à junction PN (3) formées dans un substrat (1) et alignées à la manière d'une matrice et une pluralité de registres à décalage CCD comportant des canaux CCD (2) formés dans ledit substrat, les photodiodes de chaque ligne de la matrice étant couplées à des étages respectifs d'un registre à décalage CCD associé par des régions de grille de transfert respectives (5), lesdits registres à décalage CCD comportant des moyens d'électrodes de registre (7, 8, 9, 10) qui s'étendent par dessus lesdits canaux CCD (2) des registres à décalage et qui comprennent des parties s'étendant par dessus des régions entre des photodiodes adjacentes (3) de la même ligne, lesdits moyens d'électrodes de registre s'étendant également par dessus lesdites régions de grille de transfert (5) jusqu'aux bords des photodiodes, ledit circuit de commande pouvant fonctionner de manière à appliquer des signaux d'horloge ($\phi_1$, $\phi_2'$, $\phi_3$, $\phi_4'$; $\phi_1$, $\phi_2''$, $\phi_3$, $\phi_4''$) auxdits moyens d'électrodes de registre de manière à entraîner le transfert de charges accumulées par l'intermédiaire desdites régions de grille de transfert (5) jusqu'aux étages de registre et à entraîner le déplacement de ces charges le long des registres, caractérisé en ce que lesdits moyens de circuit de commande sont prévus de telle manière que lorsqu'un niveau de signal de transfert ($V_H$) est appliqué auxdits moyens d'électrodes de registre pour effectuer ledit transfert de charge, le niveau de signal ($V_I$ ou $V_L$) appliqué auxdites parties desdits moyens d'électrodes entre des photodiodes adjacentes (3) est inférieur audit niveau de signal de transfert ($V_H$) de manière à maintenir l'isolement électrique entre lesdites photodiodes adjacentes (3) de la même ligne malgré l'absence dans ledit substrat de tout barrage de canaux entre les photodiodes adjacentes de la même ligne.

FIG. 1(a)

FIG. 1(c)

FIG. 1(b)

FIG.2

EP 0 100 199 B1

FIG. 3(a)

FIG.3(c)

FIG. 3(b)

FIG. 4

FIG. 5

FIG. 6 (a)

FIG. 6 (b)

FIG. 7(a)

FIG. 7(c)

FIG. 7(b)